# EUROPEAN PATENT APPLICATION

(11) **EP 4 719 026 A2**
(43) Date of publication of application: **01.04.2026**
(21) Application number: 25191239.0
(22) Date of filing: 23.07.2025
(51) Int. Cl.: H10W 20/00, H10W 20/20, H10W 20/42, H10W 20/41, H10W 20/40

(54) **SELF-ALIGNED BACKSIDE VIAS USING ENDPOINTED SUBFIN ETCH**

(30) Priority: 27.09.2024 US 202418899493
(71) Applicant: INTEL Corporation, Santa Clara, CA 95054 (US)
(72) Inventor: MURTHY, Anand, Portland, OR, 97229 (US); MUKHERJEE, Srijit, Portland, OR, 97229 (US); AREFIN, Nazmul, Beaverton, OR, 97006 (US); KOHEN, David, Hillsboro, OR, 97123 (US)
(74) Representative: Viering, Jentschura & Partner mbB Patent- und Rechtsanwälte

(57) **Abstract**

Semiconductor devices and systems with self-aligned backside contacts, and methods of forming the same, are disclosed herein. In one example, a semiconductor device includes a channel, a source and a drain, source and drain contacts, and a gate. The channel includes multiple channel structures arranged vertically and substantially in parallel. The source and the drain are at opposite ends of the channel. The source and drain contacts are coupled to the source and the drain, respectively. Moreover, one of the source contact or the drain contact is above the source or the drain and the other of the source contact or the drain contact is below the source or the drain. The gate is around the channel structures, where a portion of the gate below the channel structures is thicker than respective portions of the gate between the channel structures in cross-section view.

## Description

### BACKGROUND

Backside power delivery is a technology for semiconductor chips where electrical power is supplied to the active circuitry (e.g., transistors) from the backside of a chip rather than the frontside. A chip with backside power delivery typically includes backside and frontside interconnects, along with electrical connections between the backside and frontside for power delivery and signaling to/from the active circuitry. In some cases, for example, the active circuitry may include frontside and backside contacts on the sources and drains of transistors, which may be connected to the respective frontside and backside interconnects. During fabrication of chips with frontside and backside contacts, however, it can be challenging to align the backside contacts with the frontside sources/drains while also maintaining precise control over the critical dimensions of the backside contacts.

### BRIEF DESCRIPTION OF THE DRAWINGS

**FIG. 1** illustrates a cross-section view of a semiconductor device with self-aligned backside vias.
**FIGS. 2A-P** illustrate a process flow for forming a semiconductor device with self-aligned backside vias.
**FIGS. 3A-B** illustrate features that may be present in semiconductor devices with self-aligned backside vias.
**FIG. 4** illustrates a cross-section view of an integrated circuit with self-aligned backside vias.
**FIG. 5** illustrates a flowchart for forming an integrated circuit with self-aligned backside vias.
**FIG. 6** illustrates a top view of a wafer and dies that may be included in a microelectronic assembly.
**FIG. 7** illustrates a cross-sectional side view of an integrated circuit device that may be included in a microelectronic assembly.
**FIGS. 8A-D** illustrate perspective views of example planar, FinFET, gate-all-around, and stacked gate-all-around transistors.
**FIG. 9** illustrates a cross-sectional side view of an integrated circuit device assembly that may include a microelectronic assembly.
**FIG. 10** illustrates a block diagram of an example electrical device that may include a microelectronic assembly.

### DETAILED DESCRIPTION

Backside power delivery is a technology for semiconductor chips where electrical power is supplied to the active circuitry (e.g., transistors) from the backside of a chip rather than the frontside. A chip with backside power delivery typically includes backside and frontside interconnects, along with electrical connections between the backside and frontside for power delivery and signaling to/from the active circuitry. In some cases, for example, the active circuitry may include frontside and backside contacts on the sources and drains of transistors, which may be connected to the respective frontside and backside interconnects. During fabrication of chips with frontside and backside contacts, however, it can be challenging to align the backside contacts with the frontside sources and drains while also maintaining precise control over the critical dimensions of the backside contacts.

As a result, self-aligned backside vias are critical technical drivers for enabling backside power delivery while mitigating the technical challenges of via patterning with incoming wafer bow. In particular, precise control over the dimensions of self-aligned backside vias in the subfin region is of paramount importance, with direct correlation to successful contact to the sources/drains from the backside, and indirect impact on epitaxial growth when a self-aligned backside via structure is etched, filled, and recessed, as it redefines the subfin boundary. In some cases, a well-positioned recessed dummy backside contact (e.g., made of a layer of titanium nitride (TiN)) may be used for post-frontend processing, including etching the backside dummy contact and backfilling it with low-temperature epitaxial silicon (Si) or silicon germanium (SiGe), to enable the aforementioned scheme for backside power delivery contact establishment. The recess etching of the dummy contact backfill (e.g., TiN) from the frontside needs to be of accurate depth to make space for frontside source/drain epitaxial structures (epis) to grow for all devices/transistors with backside contacts, and to function effectively as a fully self-aligned point for post-wafer flip epi contact growth (e.g., by removing and replacing the dummy contact backfill during backside processing).

Accordingly, this disclosure presents methods of forming self-aligned backside vias using endpointed subfin etching, along with devices and systems including the same. In some embodiments, for example, the described solution may be used to enable self-aligned backside power delivery vias for on-silicon architectures with backside power delivery.

In particular, the described solution uses a critical dimension (CD)-neutral etch stop layer to provide optimized control over the recess etch of the dummy backside contact (e.g., TiN) from the frontside of the wafer. A distinguishable Group IV epi marker layer with optimized thickness will be deposited prior to the gate-all-around (GAA) superlattice stack deposition. In some embodiments, for example, the marker layer may include: (i) silicon germanium (SiGe) with isotope-purified silicon (Si) and/or isotope-purified germanium (Ge); (ii) silicon doped with arsenic (Si:As) or silicon germanium doped with arsenic (SiGe:As); (iii) silicon doped with phosphorus (Si:P) or silicon germanium doped with phosphorus (SiGe:P); (iv) silicon doped with boron (Si:B) or silicon germanium doped with boron (SiGe:B); (v) silicon doped with carbon (Si:C); or (vi) isotope-purified silicon (Si).

This marker layer will serve as an endpointed etch stop marker for the recess etch of the dummy backside contact (e.g., TiN layer) from the frontside, using the etch signal from a neighboring source/drain cavity that does not require a backside contact.

The described embodiments may provide various advantages, including reducing the impact of critical dimension (CD) variability in time-based etching using a marker layer to enable endpoint detection to stop the dummy contact (e.g., TiN) etch for backside contact locations, and enabling the backside contacts to be properly connected without any leftover dummy contact backfill (e.g., TiN) while reducing the chances of over etching the frontside source/drain epis.

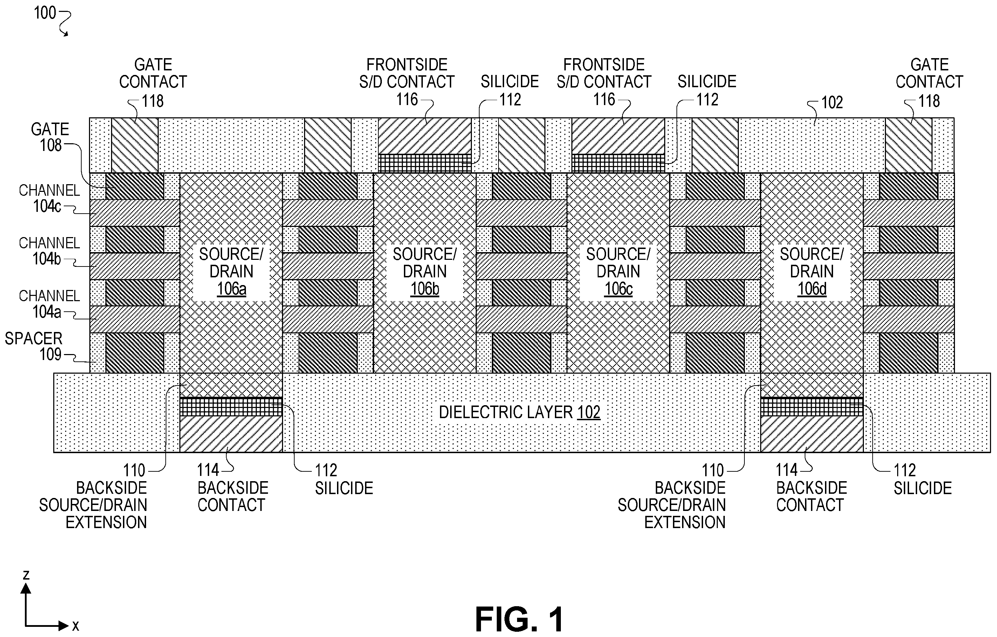

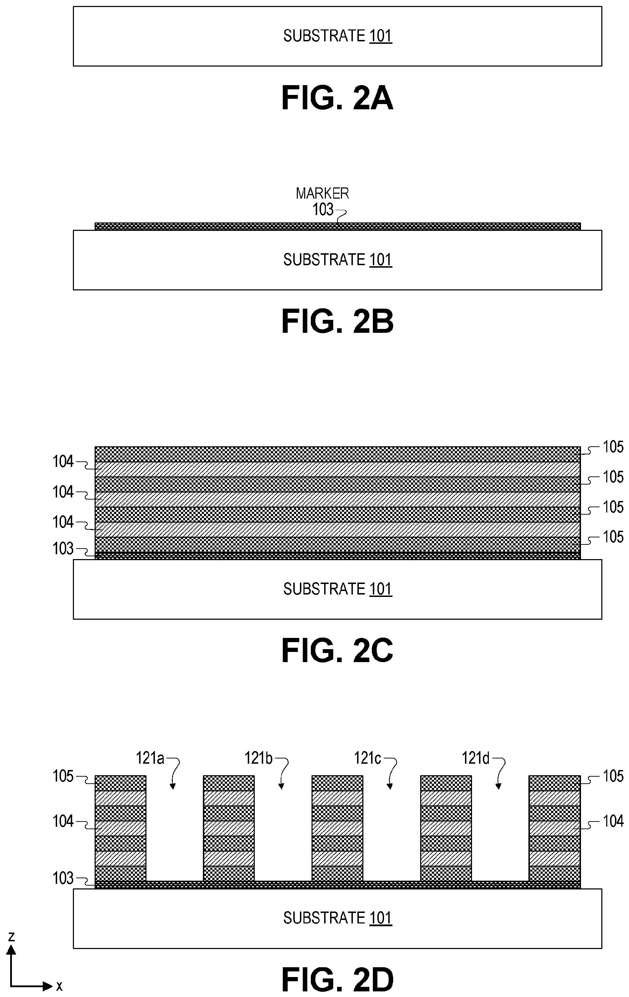

**FIG. 1** illustrates a cross-section view (x-z plane) of an example semiconductor device 100 with self-aligned backside vias. In particular, during fabrication of devices with frontside and backside contacts 116, 114, it can be challenging to align the backside contacts 114 with the frontside source/drain regions 106a-d while also maintaining precise control over the critical dimensions of the backside contacts 114. Accordingly, in the illustrated embodiment, device 100 is fabricated with self-aligned backside vias using endpointed subfin etching. For example, the vias containing the backside source/drain extensions 110, backside silicide 112, and backside contact metal 114 are formed using a process flow that uses endpointed subfin etching to self-align the backside vias with the source/drain regions 106a-d. The process flow for forming device 100 is described in further detail in connection with FIGS. 2A-P.

In the illustrated embodiment, semiconductor device 100 includes dielectric layers 102, channel structures 104a-c, source/drain regions 106a-d, frontside and backside source/drain contacts 116, 114 (and associated silicide layers 112), backside source/drain extensions 110, gates 108, gate spacers 109, and gate contacts 118.

The channel structures 104a-c are stacked vertically and extend substantially in parallel between adjacent source/drain regions 106a-d, collectively forming a channel between the source/drain regions 106a-d. In some embodiments, the channel structures 104a-c may be nanoribbons, nanowires, or nanosheets made of silicon.

The sources/drains 106a-d may be epitaxially grown structures formed using any suitable materials, such as silicon doped with phosphorus or arsenic for n-type transistors (e.g., n-type metal-oxide-semiconductor (NMOS) transistors), or silicon doped with boron for p-type transistors (e.g., p-type metal-oxide-semiconductor (PMOS) transistors).

The frontside and backside source/drain contacts 116, 114 (and the associated silicide layers 112) are coupled to the source/drain regions 106a-d. In particular, the respective frontside contacts 116 are coupled to the frontside of a corresponding source or drain 106b,c (e.g., above the source or drain 106b,c), and the respective backside contacts 114 are coupled to the backside of a corresponding source or drain 106a,d (e.g., below the source or drain 106a,d).

The respective gates 108 are formed around the channel structures 104a-c, and a gate contact 118 is coupled to each gate 118 (e.g., above the gate 108 on the frontside).

In the illustrated embodiment, the elements of semiconductor device 100 collectively form a layer of gate-all-around (GAA) transistors. In some embodiments, the GAA transistors may be used for backside power delivery, where power is supplied from the backside (e.g., below the GAA transistors), while signaling is performed primarily on the frontside (e.g., above the GAA transistors).

The process flow for forming semiconductor device 100 is described in further detail below in connection with FIGS. 2A-P.

**FIGS. 2A-P** illustrate an example process flow for forming a semiconductor device 100 with self-aligned backside vias. In the illustrated example, FIGS. 2A-P show cross-section (x-z plane) views after performing various steps of the process flow. It will be appreciated in light of the present disclosure that the illustrated process flow is only one example methodology for arriving at a semiconductor device with self-aligned backside vias.

In FIG. 2A, a substrate 101 is received. In some embodiments, the substrate 101 may include silicon (e.g., a silicon wafer).

In FIG. 2B, a marker layer 103 is formed over the substrate 101 (e.g., to aid in forming the self-aligned backside vias in subsequent steps of the process flow). In some embodiments, for example, the marker layer 103 may include a distinguishable Group IV material, which refers to a material that includes elements from Group IV of the periodic table and is distinguishable from the Si substrate 101 and the Si/SiGe superlattice layers 105, 104. Moreover, the marker layer 103 may be formed via epitaxial growth or deposition of the particular Group IV material over the substrate 101.

In some embodiments, the distinguishable Group IV epitaxial material used to form the marker layer 103 may include any of the following materials: (i) silicon germanium (SiGe) with isotopic silicon (Si) and/or isotopic germanium (Ge); (ii) silicon doped with arsenic (Si:As) or silicon germanium doped with arsenic (SiGe:As); (iii) silicon doped with phosphorus (Si:P) or silicon germanium doped with phosphorus (SiGe:P); (iv) silicon doped with boron (Si:B) or silicon germanium doped with boron (SiGe:B); (v) silicon doped with carbon (Si:C); or (vi) isotopic silicon (Si). In various embodiments, the concentration of germanium in the marker layer 103 may vary from 0 to 100%. Isotopic silicon may refer to silicon with an isotopic abundance different from naturally abundant silicon (e.g., 28Si 92.23%, 29Si 4.67%, 30Si 3.1%). Similarly, isotopic germanium may refer germanium with an isotopic abundance different from naturally abundant germanium.

Thus, in various embodiments, the marker layer 103 may include elements such as silicon, germanium, arsenic, phosphorous, boron, and/or carbon, including any of the following combinations of the foregoing: silicon and germanium (e.g., with isotopic Si and/or isotopic Ge); silicon, germanium, and arsenic; silicon, germanium, and phosphorus; silicon, germanium, and boron; silicon and arsenic; silicon and phosphorus; silicon and boron; silicon and carbon; or isotopic silicon.

In FIG. 2C, a superlattice is formed over the marker layer 103. In the illustrated embodiment, the superlattice includes a stack of alternating layers of silicon germanium (SiGe) 105 and silicon (Si) 104. The layers of silicon 104 will subsequently be used to form the channel

(e.g., silicon nanoribbons, nanowires, nanosheets) of a transistor in subsequent steps of the process flow. In other embodiments, the layers of the superlattice may include other types or combinations of materials.

In FIG. 2D, the SiGe/Si superlattice layers 105, 104 are patterned into fins. In particular, the superlattice layers 105, 104 are etched down to the marker layer 103 (e.g., without etching the marker layer 103) in areas 121 where sources/drains will be formed in subsequent processing steps, thus forming "fins" of SiGe/Si superlattices 105, 104, which are separated by trenches 121a-d (e.g., cavities) that extend down to the marker layer 103. In this manner, the marker layer 103 is retained on the substrate 101 after the superlattice fins 104, 105 are patterned.

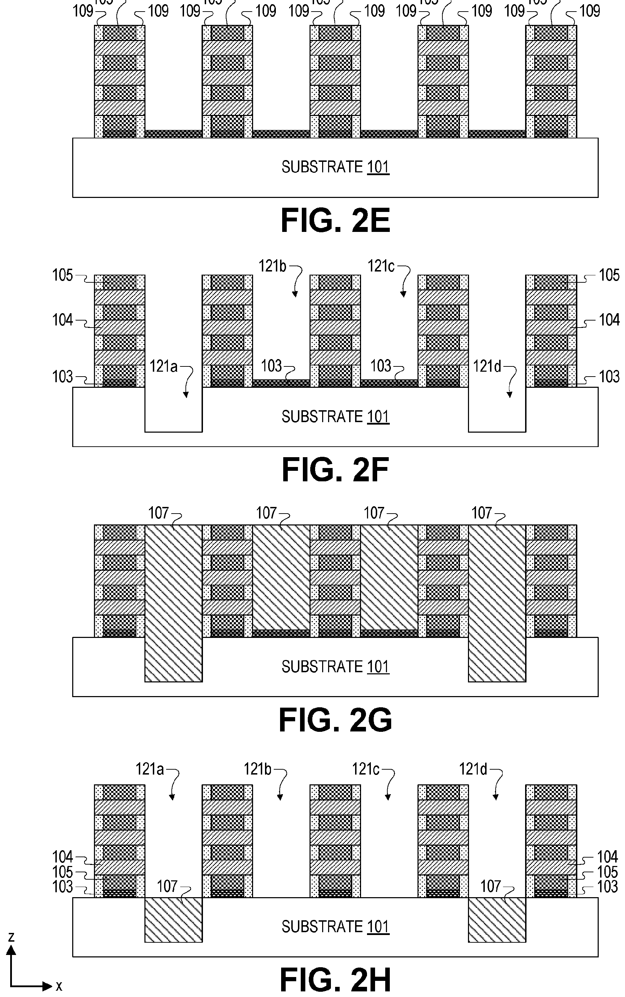

In FIG. 2E, gate spacers 109 are formed on the sides of the fins in the SiGe layers 105. In particular, the ends or tips of the SiGe layers 105 may be etched away and filled with a dielectric material. In this manner, the gate spacers 109 will serve as sidewalls on the gates to create separation between the gates and the sources/drains after subsequent steps of the process flow.

In FIG. 2F, the trenches 121a,d for sources/drains that will have backside contacts are opened and etched (from the frontside) through the marker layer 103 and into the substrate 101 to define the positions of the self-aligned vias that will be formed in subsequent steps of the process flow. In this manner, some of the trenches 121b,c extend to the marker layer 103 (e.g., for sources/drains that will have frontside contacts), while other trenches 121a,d extend through the marker layer 103 and into the substrate 101 (e.g., for sources/drains that will have backside contacts).

In FIG. 2G, all of the trenches 121a-d from FIG. 2F are opened and filled with a sacrificial fill material 107 (e.g., titanium nitride (TiN)) and then polished. The sacrificial fill material 107 will be used to form dummy backside contacts in subsequent steps of the process flow.

In FIG. 2H, the sacrificial fill material 107 (e.g., TiN) in the trenches 121a-d is recessed down to the subfin level (e.g., below the lowest SiGe layer 105 and/or the marker layer 103) using the marker layer 103 as an etch endpoint. In some embodiments, for example, the sacrificial fill material 107 in the respective trenches 121a-d is etched at least until the marker layer 103 is detected in one of the neighboring trenches 121b,c where the marker layer 103 remains intact and was not previously etched through. In particular, a mass spectrometer may be used to detect the atomic species in the marker layer 103 once it becomes exposed during the etch (e.g., by detecting silicon and/or germanium ions, or specific dopant species, depending on the morphology and materials used to form the marker layer 103 in FIG. 2B).

In some embodiments, once the marker layer 103 is detected in one of the trenches 121b,c, the etch may briefly continue (e.g., for a predetermined amount of time using time-based etching) to recess the sacrificial fill material 107 below the fins (e.g., below the marker layer 103) in the trenches 121a,d that will have backside contacts, while etching away the marker layer 103 in the trenches 121b,c that will not have backside contacts.

In this manner, the sacrificial fill material 107 only remains in the subfin portion of the trenches 121a,d that will have backside contacts, thus forming dummy backside contacts 107 in those trenches 121a,d.

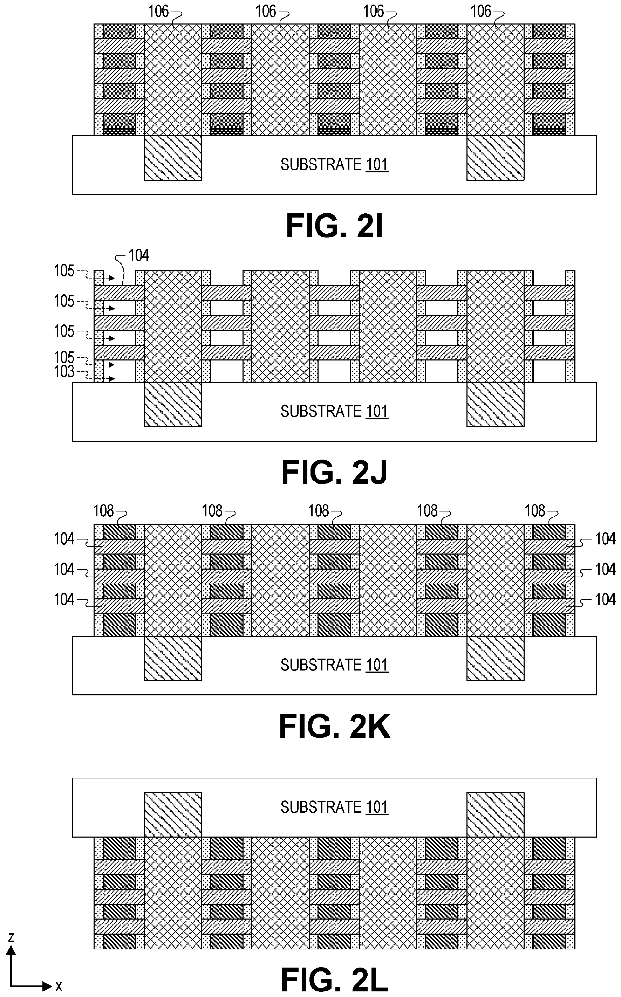

In FIG. 2I, the sources/drains 106 are formed in the trenches 121a-d from FIG. 2H. In particular, the sources/drains 106 may be epitaxially grown using any suitable materials, including silicon doped with phosphorus or silicon doped with arsenic for n-type transistors (e.g., n-type metal-oxide-semiconductor (NMOS) transistors), or silicon doped with boron for p-type transistors (e.g., p-type metal-oxide-semiconductor (PMOS) transistors).

In FIG. 2J, the sacrificial SiGe layers 105 are etched away to release the silicon layers 104, thus forming silicon channel structures 104, such as nanoribbons, nanowires, or nanosheets.

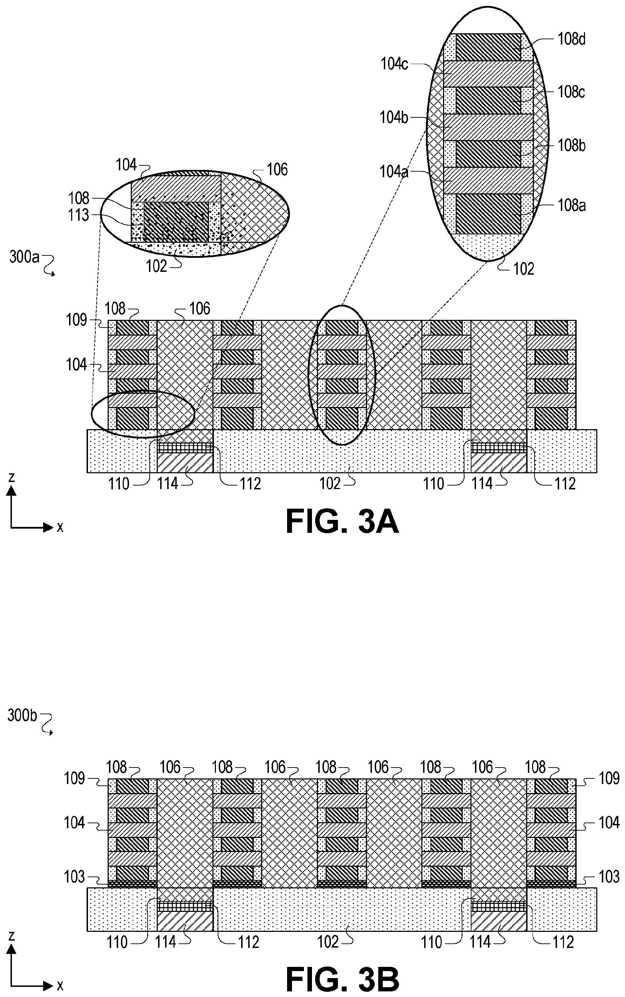

In the illustrated embodiment, the marker layer 103 is also etched away with the sacrificial SiGe layers 105. In particular, if the marker layer 103 also includes silicon germanium (e.g., with isotopic Si and/or Ge or other dopants), the marker layer 103 will be etched away during the etch of the sacrificial SiGe layers 105. After the SiGe layers 105 and marker layer 103 are etched away, the empty area resulting from the etch of the lowest SiGe layer 105 and the marker layer 103 (e.g., below the lowest channel structure 104) is thicker than the empty areas resulting from the etch of the other SiGe layers 105 (e.g., as described further in connection with semiconductor device 300a of FIG. 3A).

In other embodiments, the marker layer 103 may not be etched away with the sacrificial SiGe layers 105. In particular, if the marker layer 103 includes a material other than silicon germanium, such as isotopically-purified silicon, the marker layer 103 may not be etched away during the etch of the sacrificial SiGe layers 105. In those embodiments, portions of the marker layer 103 may remain at the bottom of the fins (e.g., as described further in connection with semiconductor device 300b of FIG. 3B).

In FIG. 2K, gates 108 are formed around the silicon channel structures 104. In some embodiments, for example, the gates 108 may be formed by depositing and patterning a high-k dielectric material (e.g., an oxide) and a gate metal (e.g., tungsten) around the channel structures 104 (e.g., filling the area where the SiGe layers 105 were located).

After the gates 108 are formed, the portion of each gate 108 below the lowest channel structure 104 is thicker than the respective portions of the gate 108 below the other channel structures 104 (e.g., as described further in connection with semiconductor device 300a of FIG. 3A).

At this point, the remaining frontside processing may be performed, such as forming conductive contacts for sources, drains, and gates, forming a frontside interconnect (e.g., primarily for signaling), inter-layer dielectric (ILD) filling and planarization, etc. These processing steps are omitted for simplicity.

In FIG. 2L, the substrate 101 is flipped over to perform backside processing (e.g., with the frontside face down and the backside face up). In some embodiments, before flipping the substrate 101 over, a carrier substrate (not shown) may be bonded to the top of the substrate stack 101 for structural support, such that the carrier substrate is at the bottom of the substrate stack 101 once it is flipped over.

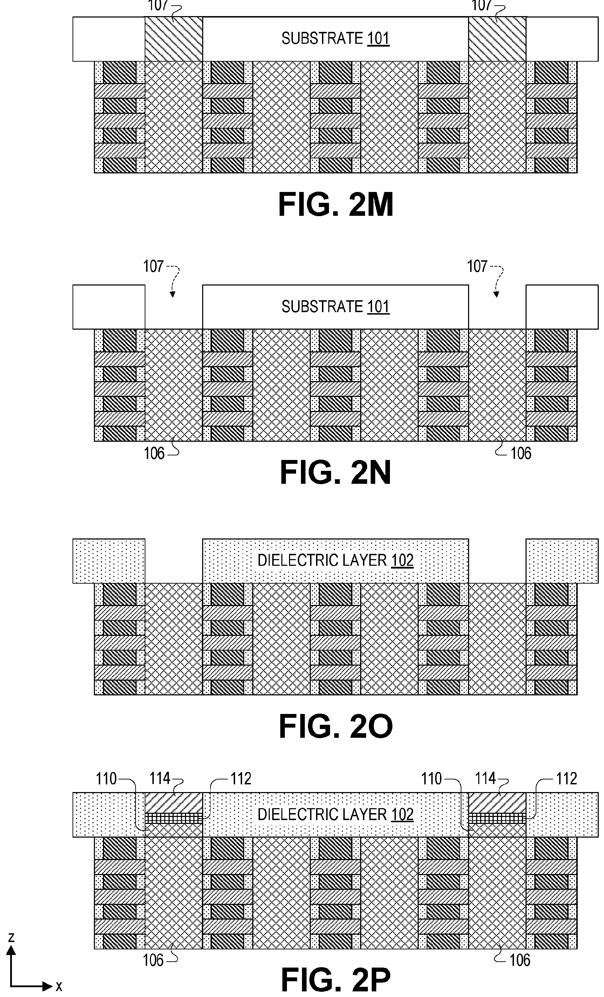

In FIG. 2M, the backside of the substrate 101 is grinded or thinned until the dummy backside contacts 107 are exposed, which will be used to form the self-aligned backside vias in subsequent process steps.

In FIG. 2N, the dummy backside contacts 107 are etched away to open a path to the corresponding epitaxial source/drain regions 106 on the frontside of the substrate 101.

In FIG. 2O, the substrate 101 is replaced with a dielectric layer 102, such as silicon oxide (SiOₓ). In particular, if backside contacts are formed in a silicon substrate 101, there may be low leakage paths between the backside contacts through the silicon substrate 101. Thus, in some embodiments, the substrate 101 may be etched or grinded away and replaced with a dielectric layer 102 to avoid low leakage paths between the backside contacts.

In FIG. 2P, the empty areas where the dummy backside contacts 107 were located are filled with an epitaxial source/drain material 110, followed by an appropriate silicide 112 (e.g., titanium silicide) and a contact metal 114 (e.g., tungsten).

In this manner, backside source/drain extensions 110 are formed on the frontside sources/drains 106. For example, while the sources/drains 106 are shown flush with the fins (e.g., gates 108) in the illustrated embodiment, in actual embodiments the sources/drains 106 may not be perfectly flush with the fins. As a result, the self-aligned backside vias may be filled with an epitaxially grown source/drain material 110 to effectively extend the source/drain regions 106. In some embodiments, for example, the backside source/drain extension 110 may be formed using any suitable source/drain material, including the same material used for the sources/drains 106, but grown at low temperature due to the more stringent thermal constraints during backside processing.

Moreover, the silicide 112 and contact metal 114 layers collectively form the self-aligned backside contacts or vias. In particular, the contact metal 114 serves as the fill metal for the backside contact, and the silicide 112 is used to reduce the resistance between the source/drain 106 and the contact metal 114.

At this point, the self-aligned backside contacts are complete, and the remaining backside processing may be performed, such as forming the backside interconnect (e.g., primarily for power delivery), ILD filling and planarization, etc. These processing steps are omitted for simplicity.

**FIGS. 3A-B** illustrate examples of certain features that may be present in semiconductor devices 300a,b with self-aligned backside vias. In particular, FIGS. 3A and 3B depict semiconductor devices 300a,b formed using the process flow of FIGS. 2A-P where the marker layer 103 is and is not fully etched away during processing, respectively.

In FIG. 3A, semiconductor device 300a does not include the marker layer 103, as the marker layer 103 was etched away during fabrication using the process flow of FIGS. 2A-P. In particular, if the marker layer 103 was formed with silicon germanium (SiGe) (e.g., with isotopic germanium and/or silicon, or with dopants such as phosphorus, boron, arsenic, or carbon), the marker layer 103 may be etched away during the etch of the sacrificial SiGe superlattice layers 105 in the process flow, as shown in FIG. 2J.

During processing, however, certain atomic species 113 from the marker layer 103 may diffuse into surrounding layers (e.g., due to high temperature steps, relative particle sizes, etc.). As a result, diffused atomic species 113 from the marker layer 103 may be present in and around the area where the marker layer 103 was originally formed, such as near the bottom of the gate 108 and in regions vertically and horizontally adjacent to the etched SiGe superlattice layers 105 (e.g., the fin region). In some cases, for example, the diffused atoms 113 may be present in the top subfin layer (e.g., dielectric layer 102), the gate 108, the source/drain 106, the lowest channel structure 104, or the original substrate 101 (e.g., if not removed during processing). Moreover, depending on the particular materials and dopants used to form the marker layer 103 in FIG. 2B, the diffused atomic species 113 may include phosphorus, boron, arsenic, carbon, and/or isotopic silicon (e.g., specific isotopes of silicon).

Moreover, due to the process steps involving the marker layer 103, the portion of the gate 108a below the channel structures 104a-c is thicker than the respective portions of the gate 108b-d between the channel structures 104a-c and/or above the channel structures 104a-c in cross-section view, as shown in FIG. 3A. For example, as shown in the cross-section view of FIG. 3A, the portion of the gate 108a below the lowest channel structure 104a is thicker than the respective portions of the gate 108b-d below the other channel structures 104b,c. In particular, after the marker layer 103 and SiGe superlattice layers 105 are etched away in FIG. 2J, there is more vacant area below the lowest channel structure 104a than there is below the other channel structures 104b,c. This is because, prior to the etch of the marker layer 103 and SiGe superlattice layers 105, the area below the lowest channel structure 104a included the marker layer 103 and a SiGe superlattice layer 105, while the respective areas below the other channel structures 104b,c only included a SiGe superlattice layer 105 (e.g., as shown in FIG. 2I). As a result, after the marker layer 103 and SiGe superlattice layers 105 are etched away (FIG. 2J) and the gate 108 is formed around the channel structures 104 (FIG. 2K), the portion of the gate 108a below the lowest channel structure 104a is thicker than the respective portions of the gate 108b-d below the other channel structures 104b,c, as shown in the cross-section view of FIG. 3A.

In FIG. 3B, semiconductor device 300b includes portions of the marker layer 103, as the marker layer 103 was not fully etched away during fabrication using the process flow of FIGS. 2A-P. In particular, if the marker layer 103 was formed with isotopically-purified silicon (e.g., an isotope of silicon, also referred to as isotopic silicon), the marker layer 103 may not be etched away during the etch of the sacrificial SiGe superlattice layers 105 in FIG. 2J of the process flow. As a result, in semiconductor device 300b, portions of the marker layer 103 remain under the gates 108. In particular, if the marker layer 103 was formed using isotopic silicon, layers 103 of isotopic silicon may remain below the gates 108. Moreover, atomic species 113 of the marker layer 103 may also be diffused into surrounding layers, as described above with respect to semiconductor device 300a.

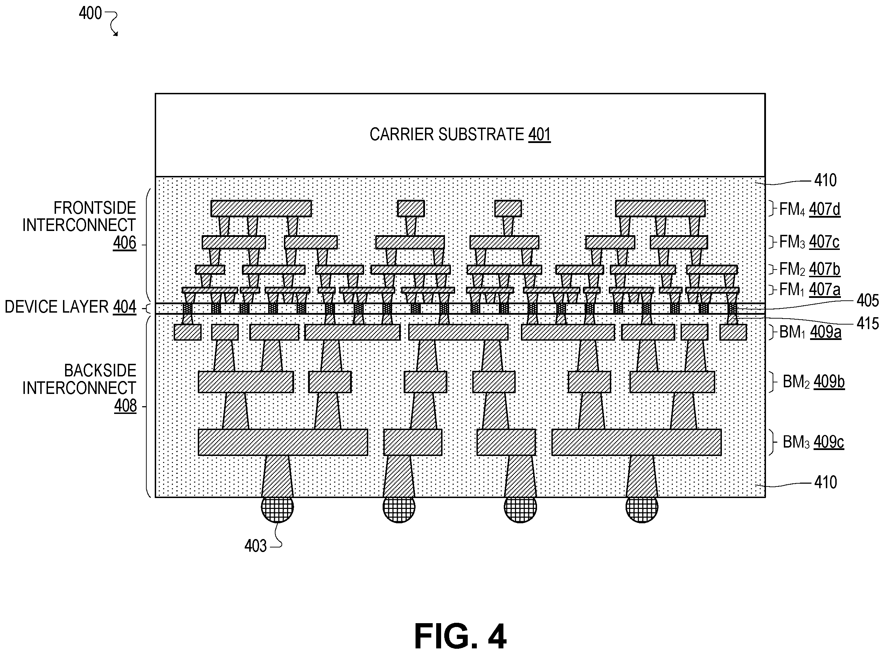

**FIG. 4** illustrates a cross-section view of an integrated circuit (IC) 400 with self-aligned backside vias in accordance with certain embodiments. In the illustrated embodiment, for example, IC 400 includes a layer 404 of transistors 405, and at least some of the transistors 405 have self-aligned backside vias, also referred to herein as backside contacts, as described throughout this disclosure.

In the illustrated embodiment, IC 400 includes a device layer 404, a frontside interconnect 406 over the device layer 404, and a backside interconnect 408 under the device layer 404. IC 400 also includes a carrier substrate 401 attached above the frontside interconnect 406 for structural support, along with conductive (e.g., metal) bumps 403 on the bottom surface to electrically couple IC 400 with another electronic device (e.g., an IC package, another IC die/chip, etc.).

In the illustrated embodiment, the original substrate on which the device layer 404 was formed is no longer present in IC 400, as it was removed (e.g., grinded or etched away) during fabrication. In other embodiments, however, IC 400 may include some or all of the original substrate below the device layer 404 (e.g., a thinned silicon substrate).

The device layer 404 includes one or more transistors 405 and/or other semiconductor devices. Moreover, at least some of the transistors 405 have self-aligned backside vias or contacts 415 to the source or drain regions. In some embodiments, for example, the transistors 405 may be implemented using the design of devices 100, 300a,b. For example, some transistors 405 may have one contact on the frontside of IC 400 (e.g., above the source or drain) and another contact 415 on the backside of IC 400 (e.g., below the other of the source or drain). Moreover, the backside contacts 415 may be formed using process flow for self-aligned backside vias described throughout this disclosure.

The frontside interconnect 406 includes multiple frontside metal (FM) layers (FM₁₋₄) 407a-d (e.g., primarily for signaling), and the backside interconnect 408 includes multiple backside metal (BM) layers (BM₁₋₃) 409a-c (e.g., primarily for power delivery/ground connections). The remaining areas are filled with one or more inter-layer dielectrics (ILDs) 410.

In the illustrated embodiment, the device layer 404 and interconnects 406, 408 collectively implement logic circuitry with associated power (V_{DD}), ground (V_{SS}), and signal networks (V_{IN}, V_{OUT}). In some embodiments, for example, the logic circuitry may be or may include processing circuitry, memory circuitry, storage circuitry, and/or communication circuitry.

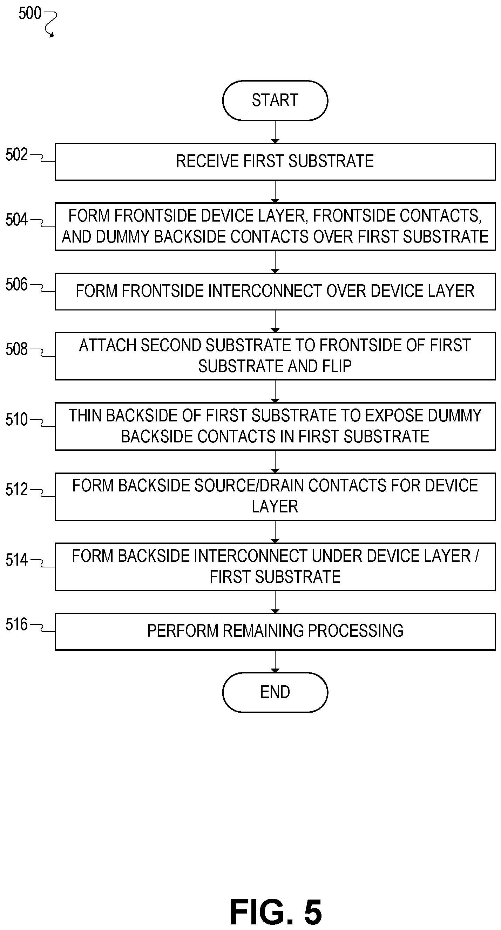

An example process flow for forming IC 400 is described below in connection with FIG. 5.

**FIG. 5** illustrates a flowchart 500 for forming an integrated circuit (IC) with self-aligned backside vias in accordance with certain embodiments. It will be appreciated in light of the present disclosure that the illustrated process flow is only one example methodology for arriving at the example IC devices shown and described throughout this disclosure (e.g., IC 400). The steps of the illustrated process flow may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metal-organic chemical vapor deposition (MOCVD), molecular beam epitaxy (MBE), atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The illustrated process flow may be used to form one or more IC dies that respectively include a device layer along with frontside and backside interconnects above and below the device layer (e.g., for signaling and power delivery). In some embodiments, the device layer and interconnects may collectively implement logic circuitry and associated signal, power, and ground nets on the respective IC dies. Moreover, at least some of the transistors in the device layer may include self-aligned backside vias or contacts (e.g., for backside power delivery), as described throughout this disclosure.

The flowchart begins at block 502 by receiving a first substrate. In some embodiments, the first substrate may be a wafer or panel and may include silicon (Si).

The flowchart then proceeds to block 504 to form a device layer, along with source/drain contacts for transistors in the device layer, over the first substrate (e.g., on the frontside of the first substrate), which may be referred to as the frontside device layer and frontside source/drain contacts. In addition, dummy backside source/drain contacts may also be formed in the first substrate (e.g., to aid in forming the actual backside contacts at block 512). In some embodiments, the device layer, frontside contacts, and dummy backside contacts may be formed using the process steps shown in FIGS. 2A-K.

In particular, the device layer may include one or more semiconductor devices, such as transistors (e.g., CMOS, PMOS, NMOS), to implement the logic circuitry of the respective IC dies. Further, at least some of the transistors may require frontside and backside contacts, where one of the contacts is on the frontside of the first substrate (e.g., above the source or drain) and the other contact is on the backside of the first substrate (e.g., below the other of the source or drain). Thus, for those transistors, frontside contacts and dummy backside contacts are formed at block 504, while the actual backside contacts are formed at block 512, as described further below.

The flowchart then proceeds to block 506 to form a first interconnect over the device layer (e.g., on the frontside of the first substrate), which may be referred to as the frontside interconnect. For example, multiple conductive (e.g., metal) layers may be formed over the device layer, along with intervening dielectric layers separating the conductive layers. The conductive layers, which may also be referred to as metal layers, may be made of one or more electrically-conductive materials that include one or more metals (e.g., any of the metals/alloys described throughout this disclosure). Further, the dielectric layers may include one or more dielectric materials (e.g., any of the dielectric materials described throughout this disclosure).

Moreover, conductive traces may be patterned (e.g., etched) in the frontside conductive layers, and vias may be formed between the conductive layers (e.g., through the intervening dielectric layers) to electrically couple traces in different conductive layers. The conductive traces and vias patterned in and between the frontside conductive layers may collectively form one or more signal, power, and/or ground nets for the logic circuitry on the respective IC dies (e.g., networks of conductive traces that provide signaling, power, and ground connections).

The signal nets (e.g., V_{IN}, V_{OUT}) may include one or more conductive traces used for signaling (e.g., electrical connections between inputs and outputs of devices/transistors in the device layer), which may also be referred to as signal traces or signal routing. Further, the signal nets in the frontside interconnect may be connected to one or more corresponding signal nets formed in the backside interconnect for off-die signal routing (e.g., as described below with respect to block 514).

The power nets (e.g., V_{DD} or V_{CC}) may include one or more conductive traces for delivering power (e.g., electrical connections between the device layer and one or more power supply terminals), which may also be referred to as power traces or power routing. Further, the power nets in the frontside interconnect may be connected to one or more corresponding power nets formed in the backside interconnect (e.g., as described below with respect to block 514).

The ground nets (e.g., V_{SS}) may include one or more conductive traces for providing ground connections (e.g., electrical connections between the device layer and one or more ground/reference terminals), which may also be referred to as ground traces or ground routing. Further, the ground nets in the frontside interconnect may be connected to one or more corresponding ground nets formed in the backside interconnect (e.g., as described below with respect to block 514).

The flowchart then proceeds to block 508 to attach or bond a second substrate to the frontside of the first substrate (e.g., over the frontside interconnect) and then flip the substrate stack over. The second substrate may be referred to as a carrier substrate (e.g., a silicon carrier wafer or panel).

The flowchart then proceeds to block 510 to thin (e.g., grind) the backside of the first substrate to expose the dummy backside contacts formed in the first substrate at block 504.

The flowchart then proceeds to block 512 to form source/drain contacts under the device layer and/or the first substrate (e.g., on the backside of the first substrate), which may be referred to as the backside source/drain contacts. In some embodiments, for example, the dummy backside contacts may be etched away and replaced with the actual backside contacts (e.g., using the process steps shown in FIGS. 2L-P).

The flowchart then proceeds to block 514 to form a second interconnect under the device layer and the first substrate (e.g., on the backside of the first substrate), which may be referred to as the backside interconnect.

For example, multiple conductive (e.g., metal) layers may be formed below the device layer and first substrate, along with intervening dielectric layers separating the conductive layers. The conductive layers, which may also be referred to as backside metal layers, may be made of one or more electrically-conductive materials that include one or more metals (e.g., any of the metals/alloys described throughout this disclosure). Further, the dielectric layers may include one or more dielectric materials (e.g., any of the dielectric materials described throughout this disclosure).

Moreover, conductive traces may be patterned (e.g., etched) in the backside conductive layers, and vias may be formed between the conductive layers (e.g., through the intervening dielectric layers) to electrically couple traces in different conductive layers. The conductive traces and vias patterned in and between the backside conductive layers may collectively form one or more backside power, ground, and/or signal nets for the logic circuitry on the respective IC dies (e.g., networks of conductive traces that provide power, ground, and/or off-chip signal routing connections). For example, the backside power and ground nets may electrically couple the corresponding frontside power and ground nets to one or more backside power supply terminals and ground terminals, respectively (e.g., through the vias in the first substrate and device layer). Moreover, the backside signal net may electrically couple the corresponding frontside signal net to one or more off-die or off-chip components (e.g., through the vias in the first substrate and device layer).

In this manner, the backside interconnect is electrically coupled to the frontside interconnect (e.g., through the vias in the first substrate and device layer) to provide power delivery and ground connections, along with off-die or off-chip signal routing.

The flowchart then proceeds to block 516 to perform any remaining processing, such as inter-layer dielectric (ILD) filling, planarization, interconnect bump formation, etc. In wafer or panel process flows, the completed wafer or panel may be diced to singulate the IC dies on the wafer or panel. The singulated IC dies may then be incorporated into an IC package, circuit board, electronic device, system, etc.

At this point, the flowchart may be complete. In some embodiments, however, the flowchart may restart and/or certain blocks may be repeated. For example, in some embodiments, the flowchart may restart at block 502 to continue forming ICs with the same or similar design.

### Example Integrated Circuit Embodiments

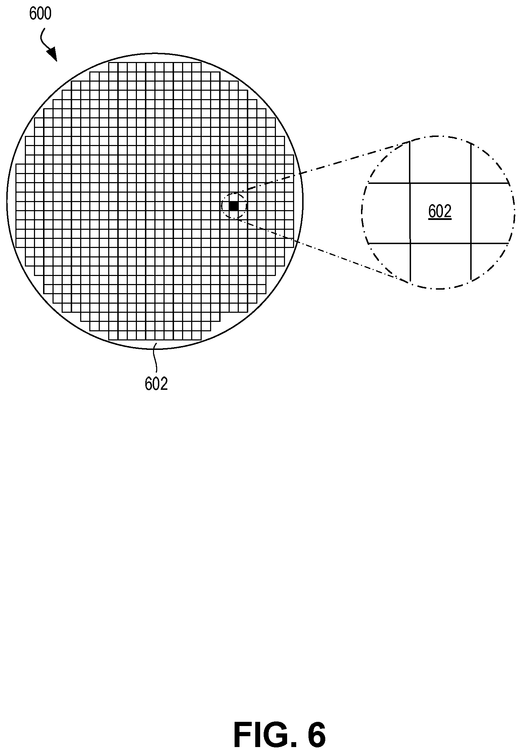

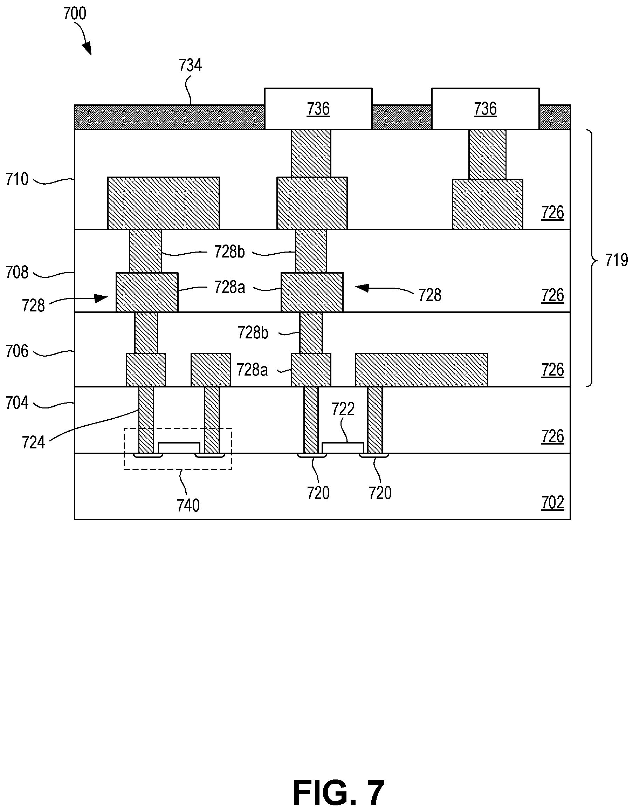

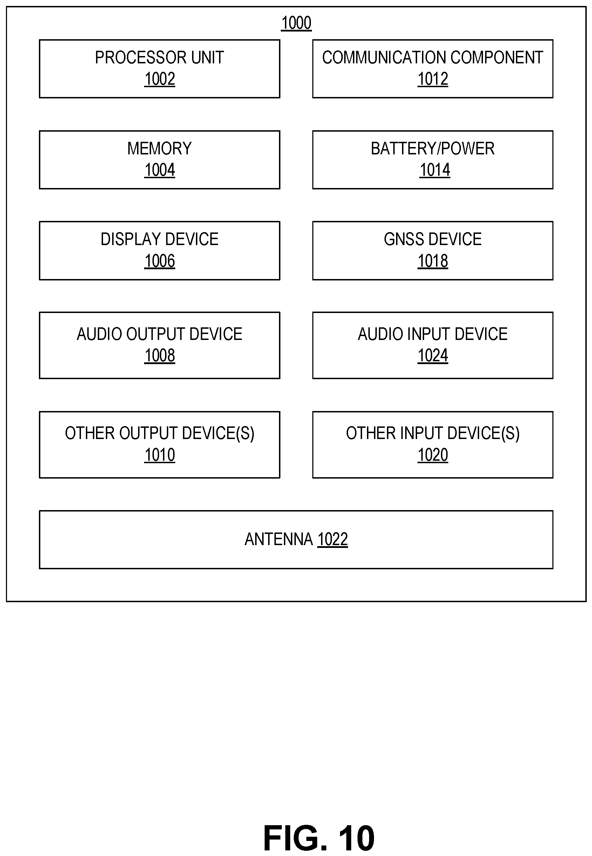

**FIG. 6** is a top view of a wafer 600 and dies 602 that may be included in, or may include, any of the embodiments disclosed herein. In some embodiments, for example, the dies 602 may include one or more semiconductor devices or transistors according to any of the embodiments disclosed herein (e.g., devices 100, 300a,b, 400). The wafer 600 may be composed of semiconductor material and may include one or more dies 602 having integrated circuit structures formed on a surface of the wafer 600. The individual dies 602 may be a repeating unit of an integrated circuit product that includes any suitable integrated circuit. After the fabrication of the semiconductor product is complete, the wafer 600 may undergo a singulation process in which the dies 602 are separated from one another to provide discrete "chips" of the integrated circuit product. The die 602 may be any of the dies disclosed herein. The die 602 may include one or more transistors (e.g., some of the transistors 740 of FIG. 7, discussed below), supporting circuitry to route electrical signals to the transistors, passive components (e.g., signal traces, resistors, capacitors, or inductors), and/or any other integrated circuit components. In some embodiments, the wafer 600 or the die 602 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 602. For example, a memory array formed by multiple memory devices may be formed on a same die 602 as a processor unit (e.g., the processor unit 1002 of FIG. 10) or other logic that is configured to store information in the memory devices or execute instructions stored in the memory array. Various ones of the microelectronic assemblies disclosed herein may be manufactured using a die-to-wafer assembly technique in which some dies are attached to a wafer 600 that include others of the dies, and the wafer 600 is subsequently singulated.

**FIG. 7** is a cross-sectional side view of an integrated circuit device 700 that may include, or may be included in, any of the embodiments disclosed herein (e.g., devices 100, 300a,b, 400, dies 602). One or more of the integrated circuit devices 700 may be included in one or more dies 602 (FIG. 6). The integrated circuit device 700 may be formed on a die substrate 702 (e.g., the wafer 600 of FIG. 6) and may be included in a die (e.g., the die 602 of FIG. 6). The die substrate 702 may be a semiconductor substrate composed of semiconductor material systems including, for example, n-type or p-type materials systems (or a combination of both). The die substrate 702 may include, for example, a crystalline substrate formed using a bulk silicon or a silicon-on-insulator (SOI) substructure. In some embodiments, the die substrate 702 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 702. Although a few examples of materials from which the die substrate 702 may be formed are described here, any material that may serve as a foundation for an integrated circuit device 700 may be used. The die substrate 702 may be part of a singulated die (e.g., the dies 602 of FIG. 6) or a wafer (e.g., the wafer 600 of FIG. 6).

The integrated circuit device 700 may include one or more device layers 704 disposed on the die substrate 702. The device layer 704 may include features of one or more transistors 740 (e.g., metal oxide semiconductor field-effect transistors (MOSFETs)) formed on the die substrate 702. The transistors 740 may include, for example, one or more source and/or drain (S/D) regions 720, a gate 722 to control current flow between the S/D regions 720, and one or more S/D contacts 724 to route electrical signals to/from the S/D regions 720. The transistors 740 may include additional features not depicted for the sake of clarity, such as device isolation regions, gate contacts, and the like. The transistors 740 are not limited to the type and configuration depicted in FIG. 7 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

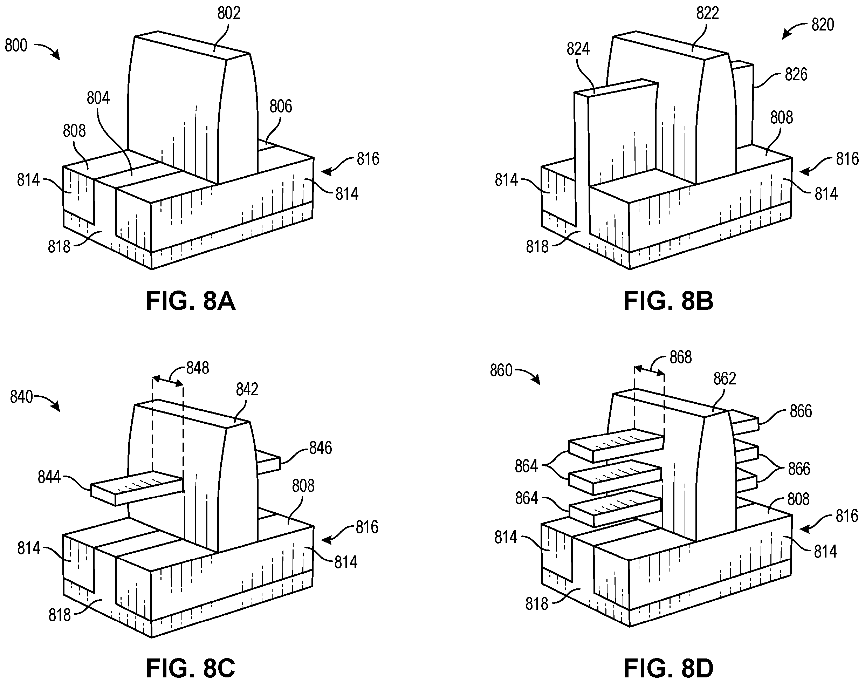

**FIGS. 8A-D** are simplified perspective views of example planar, FinFET, gate-all-around, and stacked gate-all-around transistors. In some embodiments, these transistors may be implemented according to any of the embodiments disclosed here in (e.g., devices 100, 300a,b, 400). The transistors illustrated in FIGS. 8A-8D are formed on a substrate 816 having a surface 808. Isolation regions 814 separate the source and drain regions of the transistors from other transistors and from a bulk region 818 of the substrate 816.

FIG. 8A is a perspective view of an example planar transistor 800 comprising a gate 802 that controls current flow between a source region 804 and a drain region 806. The transistor 800 is planar in that the source region 804 and the drain region 806 are planar with respect to the substrate surface 808.

FIG. 8B is a perspective view of an example FinFET transistor 820 comprising a gate 822 that controls current flow between a source region 824 and a drain region 826. The transistor 820 is non-planar in that the source region 824 and the drain region 826 comprise "fins" that extend upwards from the substrate surface 818. As the gate 822 encompasses three sides of the semiconductor fin that extends from the source region 824 to the drain region 826, the transistor 820 can be considered a tri-gate transistor. FIG. 8B illustrates one S/D fin extending through the gate 822, but multiple S/D fins can extend through the gate of a FinFET transistor.

FIG. 8C is a perspective view of a gate-all-around (GAA) transistor 840 comprising a gate 842 that controls current flow between a source region 844 and a drain region 846. The transistor 840 is non-planar in that the source region 844 and the drain region 846 are elevated from the substrate surface 828.

FIG. 8D is a perspective view of a GAA transistor 860 comprising a gate 862 that controls current flow between multiple elevated source regions 864 and multiple elevated drain regions 866. The transistor 860 is a stacked GAA transistor as the gate controls the flow of current between multiple elevated S/D regions stacked on top of each other. The transistors 840 and 860 are considered gate-all-around transistors as the gates encompass all sides of the semiconductor portions that extends from the source regions to the drain regions. The transistors 840 and 860 can alternatively be referred to as nanowire, nanosheet, or nanoribbon transistors depending on the width (e.g., widths 848 and 868 of transistors 840 and 860, respectively) of the semiconductor portions extending through the gate.

Returning to FIG. 7, a transistor 740 may include a gate 722 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 740 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 740 along the source-channel-drain direction, the gate electrode may consist of a U-shaped structure that includes a bottom portion substantially parallel to the surface of the die substrate 702 and two sidewall portions that are substantially perpendicular to the top surface of the die substrate 702. In other embodiments, at least one of the metal layers that form the gate electrode may simply be a planar layer that is substantially parallel to the top surface of the die substrate 702 and does not include sidewall portions substantially perpendicular to the top surface of the die substrate 702. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 720 may be formed within the die substrate 702 adjacent to the gate 722 of individual transistors 740. The S/D regions 720 may be formed using an implantation/diffusion process or an etching/deposition process, for example. In the former process, dopants such as boron, aluminum, antimony, phosphorous, or arsenic may be ion-implanted into the die substrate 702 to form the S/D regions 720. An annealing process that activates the dopants and causes them to diffuse farther into the die substrate 702 may follow the ion-implantation process. In the latter process, the die substrate 702 may first be etched to form recesses at the locations of the S/D regions 720. An epitaxial deposition process may then be carried out to fill the recesses with material that is used to fabricate the S/D regions 720. In some implementations, the S/D regions 720 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 720 may be formed using one or more alternate semiconductor materials such as germanium or a group III-V material or alloy. In further embodiments, one or more layers of metal and/or metal alloys may be used to form the S/D regions 720.

Electrical signals, such as power and/or input/output (I/O) signals, may be routed to and/or from the devices (e.g., transistors 740) of the device layer 704 through one or more interconnect layers disposed on the device layer 704 (illustrated in FIG. 7 as interconnect layers 706-710). For example, electrically conductive features of the device layer 704 (e.g., the gate 722 and the S/D contacts 724) may be electrically coupled with the interconnect structures 728 of the interconnect layers 706-710. The one or more interconnect layers 706-710 may form a metallization stack (also referred to as an "ILD stack") 719 of the integrated circuit device 700.

The interconnect structures 728 may be arranged within the interconnect layers 706-710 to route electrical signals according to a wide variety of designs; in particular, the arrangement is not limited to the particular configuration of interconnect structures 728 depicted in FIG. 7. Although a particular number of interconnect layers 706-710 is depicted in FIG. 7, embodiments of the present disclosure include integrated circuit devices having more or fewer interconnect layers than depicted.

In some embodiments, the interconnect structures 728 may include lines 728a and/or vias 728b filled with an electrically conductive material such as a metal. The lines 728a may be arranged to route electrical signals in a direction of a plane that is substantially parallel with a surface of the die substrate 702 upon which the device layer 704 is formed. For example, the lines 728a may route electrical signals in a direction in and out of the page and/or in a direction across the page from the perspective of FIG. 7. The vias 728b may be arranged to route electrical signals in a direction of a plane that is substantially perpendicular to the surface of the die substrate 702 upon which the device layer 704 is formed. In some embodiments, the vias 728b may electrically couple lines 728a of different interconnect layers 706-710 together.

The interconnect layers 706-710 may include a dielectric material 726 disposed between the interconnect structures 728, as shown in FIG. 7. In some embodiments, dielectric material 726 disposed between the interconnect structures 728 in different ones of the interconnect layers 706-710 may have different compositions; in other embodiments, the composition of the dielectric material 726 between different interconnect layers 706-710 may be the same. The device layer 704 may include a dielectric material 726 disposed between the transistors 740 and a bottom layer of the metallization stack as well. The dielectric material 726 included in the device layer 704 may have a different composition than the dielectric material 726 included in the interconnect layers 706-710; in other embodiments, the composition of the dielectric material 726 in the device layer 704 may be the same as a dielectric material 726 included in any one of the interconnect layers 706-710.

A first interconnect layer 706 (referred to as Metal 1 or "M1") may be formed directly on the device layer 704. In some embodiments, the first interconnect layer 706 may include lines 728a and/or vias 728b, as shown. The lines 728a of the first interconnect layer 706 may be coupled with contacts (e.g., the S/D contacts 724) of the device layer 704. The vias 728b of the first interconnect layer 706 may be coupled with the lines 728a of a second interconnect layer 708.

The second interconnect layer 708 (referred to as Metal 2 or "M2") may be formed directly on the first interconnect layer 706. In some embodiments, the second interconnect layer 708 may include via 728b to couple the lines 728 of the second interconnect layer 708 with the lines 728a of a third interconnect layer 710. Although the lines 728a and the vias 728b are structurally delineated with a line within individual interconnect layers for the sake of clarity, the lines 728a and the vias 728b may be structurally and/or materially contiguous (e.g., simultaneously filled during a dual-damascene process) in some embodiments.

The third interconnect layer 710 (referred to as Metal 3 or "M3") (and additional interconnect layers, as desired) may be formed in succession on the second interconnect layer 708 according to similar techniques and configurations described in connection with the second interconnect layer 708 or the first interconnect layer 706. In some embodiments, the interconnect layers that are "higher up" in the metallization stack 719 in the integrated circuit device 700 (i.e., farther away from the device layer 704) may be thicker that the interconnect layers that are lower in the metallization stack 719, with lines 728a and vias 728b in the higher interconnect layers being thicker than those in the lower interconnect layers.

The integrated circuit device 700 may include a solder resist material 734 (e.g., polyimide or similar material) and one or more conductive contacts 736 formed on the interconnect layers 706-710. In FIG. 7, the conductive contacts 736 are illustrated as taking the form of bond pads. The conductive contacts 736 may be electrically coupled with the interconnect structures 728 and configured to route the electrical signals of the transistor(s) 740 to external devices. For example, solder bonds may be formed on the one or more conductive contacts 736 to mechanically and/or electrically couple an integrated circuit die including the integrated circuit device 700 with another component (e.g., a printed circuit board). The integrated circuit device 700 may include additional or alternate structures to route the electrical signals from the interconnect layers 706-710; for example, the conductive contacts 736 may include other analogous features (e.g., posts) that route the electrical signals to external components. The conductive contacts 736 may serve as any of the conductive contacts described throughout this disclosure.

In some embodiments in which the integrated circuit device 700 is a double-sided die, the integrated circuit device 700 may include another metallization stack (not shown) on the opposite side of the device layer(s) 704. This metallization stack may include multiple interconnect layers as discussed above with reference to the interconnect layers 706-710, to provide conductive pathways (e.g., including conductive lines and vias) between the device layer(s) 704 and additional conductive contacts (not shown) on the opposite side of the integrated circuit device 700 from the conductive contacts 736. These additional conductive contacts may serve as any of the conductive contacts described throughout this disclosure.

In other embodiments in which the integrated circuit device 700 is a double-sided die, the integrated circuit device 700 may include one or more through silicon vias (TSVs) through the die substrate 702; these TSVs may make contact with the device layer(s) 704, and may provide conductive pathways between the device layer(s) 704 and additional conductive contacts (not shown) on the opposite side of the integrated circuit device 700 from the conductive contacts 736. These additional conductive contacts may serve as any of the conductive contacts described throughout this disclosure. In some embodiments, TSVs extending through the substrate can be used for routing power and ground signals from conductive contacts on the opposite side of the integrated circuit device 700 from the conductive contacts 736 to the transistors 740 and any other components integrated into the die 700, and the metallization stack 719 can be used to route I/O signals from the conductive contacts 736 to transistors 740 and any other components integrated into the die 700.

Multiple integrated circuit devices 700 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

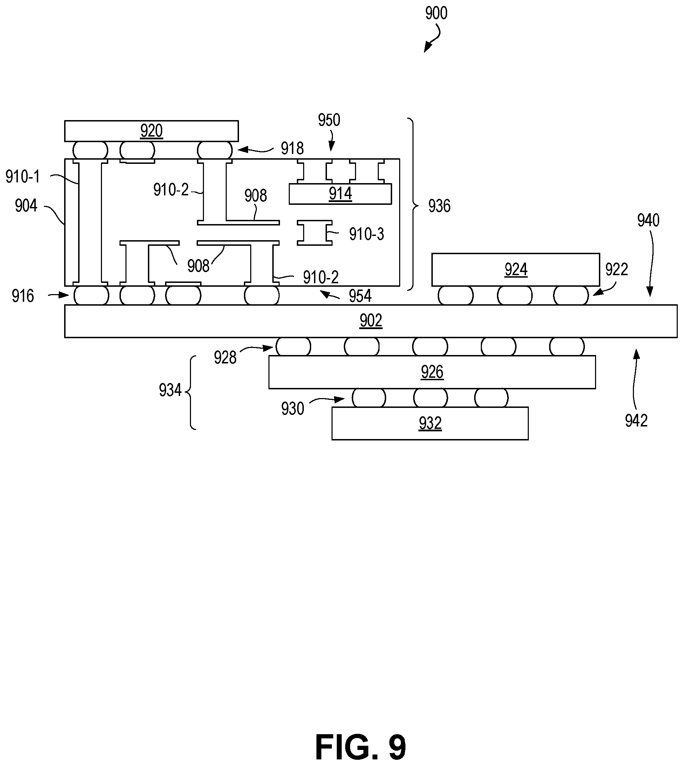

**FIG. 9** is a cross-sectional side view of an integrated circuit device assembly 900 that may include any of the embodiments disclosed herein. In some embodiments, for example, the embedded devices 914 and/or IC components 920, 924, 926, 932 of the integrated circuit device assembly 900 may include one or more transistors according to any of the embodiments disclosed herein (e.g., devices 100, 300a,b, 400). In some embodiments, the integrated circuit device assembly 900 may be a microelectronic assembly. The integrated circuit device assembly 900 includes a number of components disposed on a circuit board 902 (which may be a motherboard, system board, mainboard, etc.). The integrated circuit device assembly 900 includes components disposed on a first face 940 of the circuit board 902 and an opposing second face 942 of the circuit board 902; generally, components may be disposed on one or both faces 940 and 942. Any of the integrated circuit components discussed below with reference to the integrated circuit device assembly 900 may take the form of any suitable ones of the embodiments of the microelectronic assemblies disclosed herein.

In some embodiments, the circuit board 902 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 902. In other embodiments, the circuit board 902 may be a non-PCB substrate. The integrated circuit device assembly 900 illustrated in FIG. 9 includes a package-on-interposer structure 936 coupled to the first face 940 of the circuit board 902 by coupling components 916. The coupling components 916 may electrically and mechanically couple the package-on-interposer structure 936 to the circuit board 902, and may include solder balls (as shown in FIG. 9), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 916 may serve as the coupling components illustrated or described for any of the substrate assembly or substrate assembly components described herein, as appropriate.

The package-on-interposer structure 936 may include an integrated circuit component 920 coupled to an interposer 904 by coupling components 918. The coupling components 918 may take any suitable form for the application, such as the forms discussed above with reference to the coupling components 916. Although a single integrated circuit component 920 is shown in FIG. 9, multiple integrated circuit components may be coupled to the interposer 904; indeed, additional interposers may be coupled to the interposer 904. The interposer 904 may provide an intervening substrate used to bridge the circuit board 902 and the integrated circuit component 920.

The integrated circuit component 920 may be a packaged or unpackaged integrated circuit product that includes one or more integrated circuit dies (e.g., the die 602 of FIG. 6, the integrated circuit device 700 of FIG. 7) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 920, a single monolithic integrated circuit die comprises solder bumps attached to contacts on the die. The solder bumps allow the die to be directly attached to the interposer 904. The integrated circuit component 920 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 920 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 920 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 920 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 904 may spread connections to a wider pitch or reroute a connection to a different connection. For example, the interposer 904 may couple the integrated circuit component 920 to a set of ball grid array (BGA) conductive contacts of the coupling components 916 for coupling to the circuit board 902. In the embodiment illustrated in FIG. 9, the integrated circuit component 920 and the circuit board 902 are attached to opposing sides of the interposer 904; in other embodiments, the integrated circuit component 920 and the circuit board 902 may be attached to a same side of the interposer 904. In some embodiments, three or more components may be interconnected by way of the interposer 904.

In some embodiments, the interposer 904 may be formed as a PCB, including multiple metal layers separated from one another by layers of dielectric material and interconnected by electrically conductive vias. In some embodiments, the interposer 904 may be formed of an epoxy resin, a fiberglass-reinforced epoxy resin, an epoxy resin with inorganic fillers, a ceramic material, or a polymer material such as polyimide. In some embodiments, the interposer 904 may be formed of alternate rigid or flexible materials that may include the same materials described above for use in a semiconductor substrate, such as silicon, germanium, and other group III-V and group IV materials. The interposer 904 may include metal interconnects 908 and vias 910, including but not limited to through hole vias 910-1 (that extend from a first face 950 of the interposer 904 to a second face 954 of the interposer 904), blind vias 910-2 (that extend from the first or second faces 950 or 954 of the interposer 904 to an internal metal layer), and buried vias 910-3 (that connect internal metal layers).

In some embodiments, the interposer 904 can comprise a silicon interposer. Through silicon vias (TSV) extending through the silicon interposer can connect connections on a first face of a silicon interposer to an opposing second face of the silicon interposer. In some embodiments, an interposer 904 comprising a silicon interposer can further comprise one or more routing layers to route connections on a first face of the interposer 904 to an opposing second face of the interposer 904.

The interposer 904 may further include embedded devices 914, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 904. The package-on-interposer structure 936 may take the form of any of the package-on-interposer structures known in the art. In embodiments where the interposer is a non-printed circuit board

The integrated circuit device assembly 900 may include an integrated circuit component 924 coupled to the first face 940 of the circuit board 902 by coupling components 922. The coupling components 922 may take the form of any of the embodiments discussed above with reference to the coupling components 916, and the integrated circuit component 924 may take the form of any of the embodiments discussed above with reference to the integrated circuit component 920.

The integrated circuit device assembly 900 illustrated in FIG. 9 includes a package-on-package structure 934 coupled to the second face 942 of the circuit board 902 by coupling components 928. The package-on-package structure 934 may include an integrated circuit component 926 and an integrated circuit component 932 coupled together by coupling components 930 such that the integrated circuit component 926 is disposed between the circuit board 902 and the integrated circuit component 932. The coupling components 928 and 930 may take the form of any of the embodiments of the coupling components 916 discussed above, and the integrated circuit components 926 and 932 may take the form of any of the embodiments of the integrated circuit component 920 discussed above. The package-on-package structure 934 may be configured in accordance with any of the package-on-package structures known in the art.

**FIG. 10** is a block diagram of an example electrical device 1000 that may include one or more of the embodiments disclosed herein. For example, any suitable ones of the components of the electrical device 1000 may include one or more of the transistors (e.g., devices 100, 300a,b, 400), integrated circuit device assemblies 900, integrated circuit components 920, integrated circuit devices 700, or integrated circuit dies 602 disclosed herein. A number of components are illustrated in FIG. 10 as included in the electrical device 1000, but any one or more of these components may be omitted or duplicated, as suitable for the application. In some embodiments, some or all of the components included in the electrical device 1000 may be attached to one or more motherboards mainboards, or system boards. In some embodiments, one or more of these components are fabricated onto a single system-on-a-chip (SoC) die.

Additionally, in various embodiments, the electrical device 1000 may not include one or more of the components illustrated in FIG. 10, but the electrical device 1000 may include interface circuitry for coupling to the one or more components. For example, the electrical device 1000 may not include a display device 1006, but may include display device interface circuitry (e.g., a connector and driver circuitry) to which a display device 1006 may be coupled. In another set of examples, the electrical device 1000 may not include an audio input device 1024 or an audio output device 1008, but may include audio input or output device interface circuitry (e.g., connectors and supporting circuitry) to which an audio input device 1024 or audio output device 1008 may be coupled.

The electrical device 1000 may include one or more processor units 1002 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1002 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1000 may include a memory 1004, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1004 may include memory that is located on the same integrated circuit die as the processor unit 1002. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1000 can comprise one or more processor units 1002 that are heterogeneous or asymmetric to another processor unit 1002 in the electrical device 1000. There can be a variety of differences between the processing units 1002 in a system in terms of a spectrum of metrics of merit including architectural, microarchitectural, thermal, power consumption characteristics, and the like. These differences can effectively manifest themselves as asymmetry and heterogeneity among the processor units 1002 in the electrical device 1000.

In some embodiments, the electrical device 1000 may include a communication component 1012 (e.g., one or more communication components). For example, the communication component 1012 can manage wireless communications for the transfer of data to and from the electrical device 1000. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1012 may operate in accordance with other wireless protocols in other embodiments. The electrical device 1000 may include an antenna 1022 to facilitate wireless communications and/or to receive other wireless communications (such as AM or FM radio transmissions).

In some embodiments, the communication component 1012 may manage wired communications, such as electrical, optical, or any other suitable communication protocols (e.g., IEEE 802.3 Ethernet standards). As noted above, the communication component 1012 may include multiple communication components. For instance, a first communication component 1012 may be dedicated to shorter-range wireless communications such as Wi-Fi or Bluetooth, and a second communication component 1012 may be dedicated to longer-range wireless communications such as global positioning system (GPS), EDGE, GPRS, CDMA, WiMAX, LTE, EV-DO, or others. In some embodiments, a first communication component 1012 may be dedicated to wireless communications, and a second communication component 1012 may be dedicated to wired communications.

The electrical device 1000 may include battery/power circuitry 1014. The battery/power circuitry 1014 may include one or more energy storage devices (e.g., batteries or capacitors) and/or circuitry for coupling components of the electrical device 1000 to an energy source separate from the electrical device 1000 (e.g., AC line power).

The electrical device 1000 may include a display device 1006 (or corresponding interface circuitry, as discussed above). The display device 1006 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1000 may include an audio output device 1008 (or corresponding interface circuitry, as discussed above). The audio output device 1008 may include any embedded or wired or wirelessly connected external device that generates an audible indicator, such speakers, headsets, or earbuds.

The electrical device 1000 may include an audio input device 1024 (or corresponding interface circuitry, as discussed above). The audio input device 1024 may include any embedded or wired or wirelessly connected device that generates a signal representative of a sound, such as microphones, microphone arrays, or digital instruments (e.g., instruments having a musical instrument digital interface (MIDI) output). The electrical device 1000 may include a Global Navigation Satellite System (GNSS) device 1018 (or corresponding interface circuitry, as discussed above), such as a Global Positioning System (GPS) device. The GNSS device 1018 may be in communication with a satellite-based system and may determine a geolocation of the electrical device 1000 based on information received from one or more GNSS satellites, as known in the art.

The electrical device 1000 may include other output device(s) 1010 (or corresponding interface circuitry, as discussed above). Examples of the other output device(s) 1010 may include an audio codec, a video codec, a printer, a wired or wireless transmitter for providing information to other devices, or an additional storage device.

The electrical device 1000 may include other input device(s) 1020 (or corresponding interface circuitry, as discussed above). Examples of the other input device(s) 1020 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1000 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a display device (e.g., monitor, television), a set-top box, an entertainment control unit, a video game console, a video playback device, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1000 may be any other electronic device that processes data. In some embodiments, the electrical device 1000 may comprise multiple discrete physical components. Given the range of devices that the electrical device 1000 can be manifested as in various embodiments, in some embodiments, the electrical device 1000 can be referred to as a computing device or a computing system.

While the concepts of the present disclosure are susceptible to various modifications and alternative forms, specific embodiments thereof have been shown by way of example in the drawings and are described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features. Further, it should be understood that the various embodiments shown in the figures are illustrative representations and are not necessarily drawn to scale.

Moreover, the illustrations and/or descriptions of various embodiments may be simplified or approximated for ease of understanding, and as a result, they may not necessarily reflect the level of precision nor variation that may be present in actual embodiments. For example, while some figures generally indicate straight lines, right angles, and smooth surfaces, actual implementations of the disclosed embodiments may have less than perfect straight lines and right angles, and some features may have surface topography or otherwise be non-smooth, given real-world limitations of fabrication processes. Similarly, illustrations and/or descriptions of how components are arranged may be simplified or approximated for ease of understanding and may vary by some margin of error in actual embodiments (e.g., due to fabrication processes, etc.).

The terms "substantially," "close," "approximately," "near," and "about" may refer to being within +/- 10% of a target value unless otherwise specified.

Similarly, terms describing spatial relationships, such as "perpendicular," "orthogonal," or "coplanar," may refer to being substantially within the described spatial relationships (e.g., within +/- 10 degrees of orthogonality).

Certain terminology may also be used in the foregoing description for the purpose of reference only, and thus are not intended to be limiting. For example, terms such as "upper," "lower," "above," "below," "bottom," and "top" refer to directions in the drawings to which reference is made. Terms such as "front," "back," "rear," and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

In some embodiments, the phrase "A is located on B" or the phrase "A is adjacent to B" means that at least a part of A is in direct physical contact or indirect physical contact (having one or more other features between A and B) with at least a part of B. Moreover, the phrase "B is between A and C" means that at least part of B is in or along a space separating A and C and that at least part of B is in direct or indirect physical contact with A and C.

The terms "coupled" and "connected" may refer to either a direct or indirect connection, such as a direct electrical, mechanical, or magnetic connection, or an indirect connection through one or more passive or active intermediary elements, components, or devices.

The phrases "in an embodiment," "according to some embodiments," "in accordance with embodiments," "in embodiments," and the like may each refer to one or more of the same or different embodiments.

The terms "comprises," "comprising," "includes," "including," "having" and the like specify the presence of the stated elements (e.g., features, components, materials, steps, operations) but do not preclude the presence or addition of one or more other elements.

The phrase "and/or" as used herein refers to and encompasses any and all possible combinations of one or more of the associated listed items.

The singular forms "a," "an," and "the" are intended to include the plural forms as well, unless the context clearly indicates otherwise. For example, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

As used herein, "electrically conductive" in some examples may refer to a property of a material having an electrical conductivity greater than or equal to 10⁷ Siemens per meter (S/m) at 20 degrees Celsius. Examples of such materials include Cu, Ag, Al, Au, W, Zn, and Ni.

The terms "circuit" or "circuitry," as used in any embodiment herein may comprise, for example, singly or in any combination, hardwired circuitry, programmable circuitry such as computer processors comprising one or more individual instruction processing cores, state machine circuitry, and/or firmware that stores instructions executed by programmable circuitry. The circuitry may include a processor and/or controller configured to execute one or more instructions to perform one or more operations described herein. The instructions may be embodied as, for example, an application, software, firmware, etc. configured to cause the circuitry to perform any of the aforementioned operations. Software may be embodied as a software package, code, instructions, instruction sets and/or data recorded on a computer-readable storage device. Software may be embodied or implemented to include any number of processes, and processes, in turn, may be embodied or implemented to include any number of threads, etc., in a hierarchical fashion. Firmware may be embodied as code, instructions or instruction sets and/or data that are hard-coded (e.g., nonvolatile) in memory devices. The circuitry may, collectively or individually, be embodied as circuitry that forms part of a larger system, for example, an integrated circuit (IC), an application-specific integrated circuit (ASIC), a system-on-a-chip (SoC), desktop computers, laptop computers, tablet computers, servers, smart phones, etc. Other embodiments may be implemented as software executed by a programmable control device. In such cases, the terms "circuit" or "circuitry" are intended to include a combination of software and hardware such as a programmable control device or a processor capable of executing the software. As described herein, various embodiments may be implemented using hardware elements, software elements, or any combination thereof. Examples of hardware elements may include processors, microprocessors, circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), logic gates, registers, semiconductor device, chips, microchips, chip sets, and so forth.

For purposes of some embodiments, the transistors in various circuits and logic blocks described herein may be metal oxide semiconductor (MOS) transistors or their derivatives, where the MOS transistors include drain, source, gate, and/or bulk terminals. The transistors and/or the MOS transistor derivatives also include Tri-Gate and FinFET transistors, Gate All Around Cylindrical Transistors, Tunneling FET (TFET), Square Wire, or Rectangular Ribbon Transistors, ferroelectric FET (FeFETs), or other devices implementing transistor functionality like carbon nanotubes or spintronic devices. MOSFET symmetrical source and drain terminals are identical terminals and may be used interchangeably herein. A TFET device, on the other hand, has asymmetric Source and Drain terminals. Those skilled in the art will appreciate that other transistors, for example, Bi-polar junction transistors--BJT PNP/NPN, BiCMOS, CMOS, eFET, etc., may be used without departing from the scope of the disclosure. The term "MN" indicates an n-type transistor (e.g., NMOS, NPN BJT, etc.) and the term "MP" indicates a p-type transistor (e.g., PMOS, PNP BJT, etc.). Moreover, in some embodiments, spintronic logic devices (e.g., magnetoelectric spin-orbit (MESO) logic devices) may be used in addition to, or as an alternative to, MOS transistors.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc., as dictated by design needs or preferences, may actually comprise one or more signals that may travel in either direction and may be implemented with any suitable type of signal scheme.

In the foregoing description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, may not be described in detail in order to avoid unnecessarily obscuring embodiments of the present disclosure.

It is to be appreciated that the layers and materials described above are typically formed on or above an underlying semiconductor substrate or structure, such as underlying device layer(s) of an integrated circuit. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials. The semiconductor substrate, depending on the stage of manufacture, often includes transistors, integrated circuitry, and the like. The substrate may also include semiconductor materials, metals, dielectrics, dopants, and other materials commonly found in semiconductor substrates. Furthermore, the structures depicted above may be fabricated on underlying lower level back end of line (BEOL) interconnect layers.

Embodiments disclosed herein may be used to manufacture a wide variety of different types of integrated circuits and/or microelectronic devices. Examples of such integrated circuits include, but are not limited to, processors, chipset components, graphics processors, digital signal processors, microcontrollers, and the like. In other embodiments, semiconductor memory may be manufactured. Moreover, the integrated circuits or other microelectronic devices may be used in a wide variety of electronic devices known in the art. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

The disclosed embodiments may be implemented, in some cases, in hardware, firmware, software, or any combination thereof. The disclosed embodiments may also be implemented as instructions carried by or stored on one or more transitory or non-transitory machine-readable (e.g., computer-readable) storage media, which may be read and executed by one or more processors. A machine-readable storage medium may be embodied as any storage device, mechanism, or other physical structure for storing or transmitting information in a form readable by a machine, including volatile or non-volatile memory (e.g., random access memory (RAM), flash memory), hard drives (e.g., hard disk drive (HDD), solid state drive (SSD)), media discs, or combination thereof.

### Examples

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes a semiconductor device, comprising: a channel, wherein the channel comprises a plurality of channel structures arranged vertically and substantially in parallel; a source and a drain, wherein the source and the drain are at opposite ends of the channel; a source contact and a drain contact, wherein the source contact is coupled to the source and the drain contact is coupled to the drain, and wherein one of the source contact or the drain contact is above the source or the drain and the other of the source contact or the drain contact is below the source or the drain; and a gate around the channel structures, wherein a portion of the gate below the channel structures is thicker than respective portions of the gate between the channel structures in cross-section view.

Example 2 includes the semiconductor device of Example 1, further comprising diffused atoms near a bottom of the gate, wherein the diffused atoms comprise phosphorus, boron, arsenic, carbon, or isotopic silicon.

Example 3 includes the semiconductor device of Example 2, wherein the diffused atoms are in one or more of the gate, the source, the drain, or a lowest channel structure of the channel.

Example 4 includes the semiconductor device of any of Examples 1-3, wherein: the respective channel structures comprise silicon; the source and the drain comprise silicon doped with phosphorus, silicon doped with arsenic, or silicon doped with boron; the source contact and the drain contact respectively comprise metal; and the gate comprises metal.

Example 5 includes the semiconductor device of Example 4, wherein the gate further comprises tungsten.

Example 6 includes the semiconductor device of any of Examples 1-5, further comprising a transistor, wherein the transistor comprises the channel, the source, the drain, the source contact, the drain contact, and the gate.

Example 7 includes the semiconductor device of Example 6, wherein the channel structures are nanoribbons, nanowires, or nanosheets.

Example 8 includes the semiconductor device of Example 7, wherein the transistor is a gate-all-around (GAA) transistor.

Example 9 includes the semiconductor device of Example 6, wherein the semiconductor device is an integrated circuit.

Example 10 includes an electronic device, comprising: one or more transistors, wherein the respective transistors comprise: a channel, wherein the channel comprises a plurality of channel structures arranged vertically and substantially in parallel; a source and a drain, wherein the source and the drain are at opposite ends of the channel; a source contact and a drain contact, wherein the source contact is coupled to the source and the drain contact is coupled to the drain, and wherein one of the source contact or the drain contact is above the source or the drain and the other of the source contact or the drain contact is below the source or the drain; a gate around the channel structures; and a layer below the gate, wherein the layer comprises isotopic silicon.

Example 11 includes the electronic device of Example 10, wherein: the respective channel structures comprise silicon; the source and the drain comprise silicon doped with phosphorus, silicon doped with arsenic, or silicon doped with boron; the source contact and the drain contact respectively comprise metal; and the gate comprises metal.

Example 12 includes the electronic device of Example 11, wherein the gate further comprises tungsten.

Example 13 includes the electronic device of any of Examples 10-12, wherein the channel structures are nanoribbons, nanowires, or nanosheets.

Example 14 includes the electronic device of Example 13, wherein the one or more transistors include one or more gate-all-around (GAA) transistors.

Example 15 includes the electronic device of any of Examples 10-14, further comprising: a circuit board; and an integrated circuit coupled to the circuit board, wherein the integrated circuit comprises processing circuitry, memory circuitry, storage circuitry, or communication circuitry, wherein one or more of the transistors are comprised in the processing circuitry, the memory circuitry, the storage circuitry, or the communication circuitry.

Example 16 includes a method, comprising: forming a marker layer over a substrate; forming a superlattice over the marker layer; patterning the superlattice into fins, wherein the fins are separated by trenches, wherein at least some of the trenches extend to the marker layer and at least some of the trenches extend through the marker layer and into the substrate; filling the trenches with a fill material; recessing the fill material in the trenches, wherein the fill material is recessed at least until the marker layer is detected in one or more of the trenches; and forming sources and drains in the trenches.

Example 17 includes the method of Example 16, wherein the marker layer comprises: silicon germanium including isotopic silicon and/or isotopic germanium; silicon doped with arsenic; silicon germanium doped with arsenic; silicon doped with phosphorus; silicon germanium doped with phosphorus; silicon doped with boron; silicon germanium doped with boron; silicon doped with carbon; or isotopic silicon.

Example 18 includes the method of any of Examples 16-17, wherein the superlattice comprises alternating layers of silicon germanium and silicon.

Example 19 includes the method of Example 18, further comprising: etching the layers of silicon germanium; and forming a gate around the layers of silicon.

Example 20 includes the method of any of Examples 16-19, further comprising: grinding a backside of the substrate until the fill material is exposed; and replacing the fill material with a conductive material.

Example 21 includes the method of any of Examples 16-20, wherein the fill material is recessed below the fins in one or more of the trenches.

## Claims

1. A semiconductor device, comprising:
a channel, wherein the channel comprises a plurality of channel structures arranged vertically and substantially in parallel;
a source and a drain, wherein the source and the drain are at opposite ends of the channel;
a source contact and a drain contact, wherein the source contact is coupled to the source and the drain contact is coupled to the drain, and wherein one of the source contact or the drain contact is above the source or the drain and the other of the source contact or the drain contact is below the source or the drain; and
a gate around the channel structures, wherein a portion of the gate below the channel structures is thicker than respective portions of the gate between the channel structures in cross-section view.

2. The semiconductor device of Claim 1, further comprising diffused atoms near a bottom of the gate, wherein the diffused atoms comprise phosphorus, boron, arsenic, carbon, or isotopic silicon.

3. The semiconductor device of Claim 2, wherein the diffused atoms are in one or more of the gate, the source, the drain, or a lowest channel structure of the channel.

4. The semiconductor device of any of Claims 1-3, wherein:
the respective channel structures comprise silicon;
the source and the drain comprise silicon doped with phosphorus, silicon doped with arsenic, or silicon doped with boron;
the source contact and the drain contact respectively comprise metal; and
the gate comprises metal.

5. The semiconductor device of Claim 4, wherein the gate further comprises tungsten.

6. The semiconductor device of any of Claims 1-5, further comprising a transistor, wherein the transistor comprises the channel, the source, the drain, the source contact, the drain contact, and the gate.

7. The semiconductor device of Claim 6, wherein:
the channel structures are nanoribbons, nanowires, or nanosheets; and
the transistor is a gate-all-around (GAA) transistor.

8. The semiconductor device of Claim 6, wherein the semiconductor device is an integrated circuit.

9. An electronic device comprising the semiconductor device of any of Claims 1-8.

10. At least one machine-accessible storage medium having instructions stored thereon, wherein the instructions, when executed on a machine, cause the machine to perform a method of any one of claims 11-14 or realize an apparatus as claimed in any preceding claim.

11. A method, comprising:
forming a marker layer over a substrate;
forming a superlattice over the marker layer;
patterning the superlattice into fins, wherein the fins are separated by trenches, wherein at least some of the trenches extend to the marker layer and at least some of the trenches extend through the marker layer and into the substrate;
filling the trenches with a fill material;
recessing the fill material in the trenches, wherein the fill material is recessed at least until the marker layer is detected in one or more of the trenches; and
forming sources and drains in the trenches.

12. The method of Claim 11, wherein the marker layer comprises:
silicon germanium including isotopic silicon and/or isotopic germanium;
silicon doped with arsenic;
silicon germanium doped with arsenic;
silicon doped with phosphorus;
silicon germanium doped with phosphorus;
silicon doped with boron;
silicon germanium doped with boron;
silicon doped with carbon; or
isotopic silicon.

13. The method of any of Claims 11-12, wherein:
the superlattice comprises alternating layers of silicon germanium and silicon; and
the method further comprises:
etching the layers of silicon germanium; and
forming a gate around the layers of silicon.

14. The method of any of Claims 11-13, further comprising:
grinding a backside of the substrate until the fill material is exposed; and
replacing the fill material with a conductive material.
